# DEMANDE DE BREVET EUROPEEN

(11) **EP 3 671 842 A1**
(43) Date de publication de la demande: **24.06.2020**
(21) Numéro de dépôt: 19215884.8
(22) Date de dépôt: 13.12.2019
(51) Int. Cl.: H01L 27/15, H01L 33/20

(54) **PROCEDE DE FABRICATION DE STRUCTURES OPTOELECTRONIQUES POURVUES DE DIODES ELECTROLUMINESCENTES COPLANAIRES**

(30) Priorité: 20.12.2018 FR 1873508
(71) Demandeur: Commissariat à l'énergie atomique et aux énergies alternatives, 75015 Paris (FR); CENTRE NATIONAL DE LA RECHERCHE SCIENTIFIQUE, 75794 Paris Cedex 16 (FR)
(72) Inventeur: FEUILLET, Guy, 38054 GRENOBLE CEDEX 09 (FR); DAMILANO, Benjamin, 06200 NICE (FR); DUBOZ, Jean-Yves, 06560 VALBONNE (FR); LARGERON, Christophe, 38054 GRENOBLE CEDEX 09 (FR)
(74) Mandataire: Brevalex

(57) **Abrégé**

L'invention concerne un procédé de fabrication d'au moins une structure optoélectronique sur un substrat support (100).

En particulier, la présente invention concerne la fabrication d'une structure optoélectronique (10) pourvue d'une pluralité de diodes électroluminescentes coplanaires, et formée à partir d'une succession d'empilements électroluminescents (210, 220, 230).

La présente invention met donc en œuvre une cavité, dont le fond présente un profil étagé, de sorte que la formation de la succession d'empilements électroluminescents reproduise, sur sa face exposée, le profil étagé du fond de la cavité.

L'exécution d'une étape de nivèlement de la succession d'empilements électroluminescents par rapport à un niveau de référence défini par la portion de surface exposée à l'aplomb de la marche la plus profonde, permet alors de révéler un ensemble des diodes électroluminescentes coplanaires.

## Description

### DOMAINE TECHNIQUE

La présente invention concerne le domaine des diodes électroluminescentes.

En particulier, la présente invention concerne le domaine des diodes électroluminescentes mises en œuvre pour l'affichage et/ou la projection d'images, mais également pour l'éclairage.

La présente invention concerne à cet égard un procédé de fabrication d'une structure optoélectronique pourvue de diodes électroluminescentes agencées de manière coplanaire.

### ÉTAT DE LA TECHNIQUE ANTÉRIEURE

Au-delà de leur utilisation dans l'éclairage public ou privé, les dispositifs électroluminescents sont aujourd'hui mis en œuvre dans bon nombre d'applications, notamment pour la lithographie, la communication en lumière visible (« LIFI » ou « Light Fidelity » selon la terminologie Anglo-Saxonne), les lampes anti éblouissement des véhicules automobiles, les afficheurs tête haute ou « près de l'œil ».

Ces dispositifs sont généralement pourvus d'une matrice de pixels destinés à émettre chacun un rayonnement électromagnétique pour la formation des images ou pour l'éclairage.

Dépendamment de l'application visée, la taille des pixels peut varier entre un et plusieurs dizaines de micromètres, voire atteindre une fraction de millimètre.

À titre d'exemple, dès lors que l'afficheur est destiné à des applications dites « près de l'œil », les pixels présentent une taille de l'ordre du micromètre, tandis que pour un éclairage, plusieurs dizaines de micromètres peuvent être requises.

Quoiqu'il en soit, ces applications nécessitent toutes la mise en œuvre de pixels susceptibles d'émettre un rayonnement intense, et permettant, dès lors qu'il s'agit d'afficher une image, l'établissement d'un fort contraste.

À cet égard, les diodes électroluminescentes organiques (« OLED » ou « Organic Light Emitting Diodes » selon la terminologie Anglo-Saxonne), dont le fonctionnement permet une émission directe de lumière, sont aujourd'hui mises en œuvre pour les applications « près de l'œil ».

Toutefois, l'intensité du rayonnement lumineux émis par une OLED est encore limitée à quelques 10³ Cd/m², de sorte que ces dernières ne peuvent, pour le moment, être envisagées pour d'autres applications.

Par ailleurs, les OLED sont très sensibles à leur environnement, et notamment à l'humidité et aux variations de températures.

Pour l'éclairage automobile, il peut être considéré d'utiliser des micro diodes électroluminescentes inorganiques susceptibles d'émettre un rayonnement électromagnétique bleu, et de convertir ce dernier en lumière blanche avec, par exemple, des boîtes quantiques ou des convertisseurs à nanocristaux.

Ce principe peut également être mis en œuvre pour convertir du bleu en vert et en rouge, avec des pixels contenant des convertisseurs différents, afin d'obtenir les trois couleurs primaires sur une matrice.

Toutefois, afin d'éviter les diaphonies, une telle solution requiert un agencement de pixels compliqué. De plus, de telles solutions sont très difficiles à mettre en œuvre pour les petits pixels.

Une solution de choix réside donc dans la mise en œuvre de diodes électroluminescentes inorganiques (« LED » ou « Light Emitting Diode » selon la terminologie Anglo-Saxonne).

Par exemple, pour des applications automobiles, chaque pixel peut comprendre une ou plusieurs diodes bleues dont le rayonnement est converti, par exemple avec du phosphore, en lumière blanche.

Toujours à titre d'exemple, chaque pixel peut comprendre une pluralité de LEDs, chacune desdites LEDs étant susceptible d'émettre un rayonnement électromagnétique de longueur d'onde différente. Notamment, chaque pixel peut comprendre une diode émettant de la lumière bleue (dite diode bleue), une diode émettant de la lumière verte (dite diode verte) et une diode émettant de la lumière rouge (dite diode rouge).

Une combinaison appropriée des intensités des rayonnements émis par les diodes bleue, verte, et rouge permet de réaliser l'émission de n'importe quelle couleur du domaine visible, et notamment l'émission d'une lumière blanche pour l'éclairage dans le domaine automobile.

Ces diodes électroluminescentes comprennent en général des empilements de matériaux semi-conducteurs IIIV, comme par exemple le GaN ou encore de l'InₓGa₁₋ₓN (noté par la suite InGaN).

À cet égard, les informations nécessaires à la conception d'une LED basée sur ces matériaux sont données dans le document [1] cité à la fin de la description.

En particulier, une diode électroluminescente comprend deux couches externes faites respectivement d'un matériau semi-conducteur dopé n et d'un matériau semi-conducteur dopé p (par exemple à base d'InGaN) entre lesquelles est intercalée une couche active.

Tout au long de la description, on désigne par couche active, la couche d'une LED à partir de laquelle est émis un rayonnement électromagnétique.

Notamment, la couche active d'une LED peut comprendre un empilement de puits quantiques tel que décrit en page 9, lignes 8-17 du document [2] cité à la fin de la description.

Lorsqu'elles sont empilées, les LEDs peuvent être séparées les unes des autres par des jonctions tunnels tel que précisé en page 9 lignes 27-28 du document [2].

Les figures la à 1f illustrent les différentes étapes d'un procédé, de fabrication d'au moins une structure électroluminescente 1, et notamment au moins un pixel, pourvu par exemple de trois LED, dites, respectivement, première LED, seconde LED et troisième LED, susceptibles d'émettre chacune un rayonnement électromagnétique d'une longueur d'onde différente.

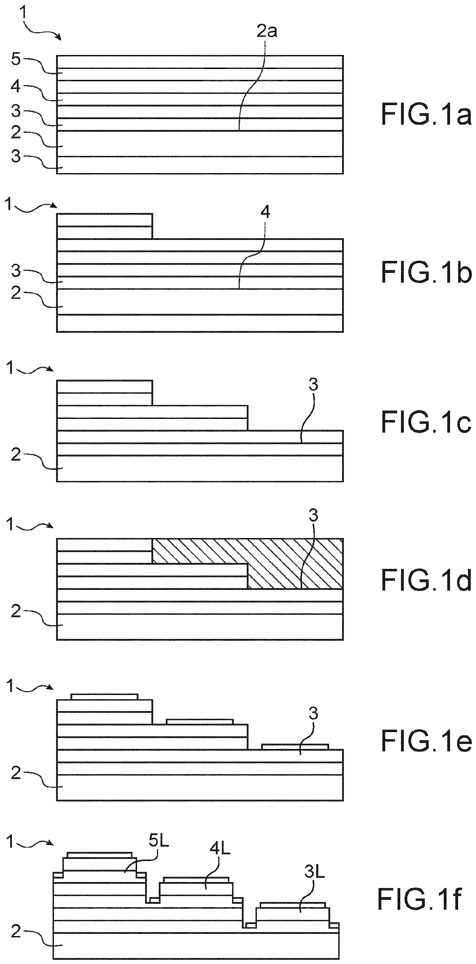

Le procédé comprend les étapes suivantes :
a) la fourniture d'un substrat support 2 pourvu d'une face dite face avant 2a ;
b) la formation, par exemple par épitaxie, d'un empilement de couches, l'empilement de couches comprend une succession d'empilements électroluminescents dits, à partir de la face avant, respectivement, premier empilement 3, second empilement 4 et troisième empilement 5, destinés à former chacun, respectivement, la première LED 3L, la seconde LED 4L et la troisième LED 5L (figure 1a) ;
c) une étape de gravure du troisième empilement destinée à définir la troisième LED (figure 1b) ;
d) une étape de gravure du second empilement destinée à définir la seconde LED et la première LED (figure le).

Ce procédé peut également comprendre la formation de contacts, dits contacts supérieurs sur la face exposée de la couche de semi-conducteur dopé p de chacune des première, seconde et troisième LED.

Cette étape de formation de contacts supérieurs implique notamment la mise en œuvre d'une étape de photolithographie, et de métallisation.

D'autres contacts, dits contacts inférieurs sont destinés à polariser la couche de semi-conducteur dopé n de chacune des LED.

Ainsi, chaque LED comprend deux contacts.

Un tel procédé n'est toutefois pas satisfaisant.

En effet, la topologie imposée par les gravures successives (étapes c et d) rend la mise en commun, pour chacune des diodes, de leurs contacts supérieurs compliquée, voire impossible.

Par ailleurs, deux étapes de photolithographies distinctes dédiées respectivement à la formation des contacts supérieurs d'une part et des contacts inférieurs d'autre part doivent être mises en œuvre.

En outre, les étapes c) et d) de gravure requièrent également, pour la définition des LED, autant d'étapes de photolithographie qu'il y a de diodes électroluminescentes par pixel.

Compte tenu des tolérances d'alignement relativement sévères, notamment lorsque la taille des pixels diminue, la multiplication des étapes de photolithographie complique le procédé, et compromet les rendements associés à la fabrication de telles structures.

Plus particulièrement, ce problème est d'autant plus important que la première gravure génère une topologie au niveau de la surface exposée qui complique la mise en œuvre de la ou des étapes de photolithographie subséquentes. Notamment, le résine photosensible, mise en œuvre lors de l'étape de photolithographie, peut présenter des non-uniformités d'épaisseur dès lors que la surface sur laquelle elle répandue n'est pas plane.

Par surcroit, la topologie de surface résultant des gravures successives complique un éventuel report des structures sur un substrat, et rend très difficile, voire impossible, l'étape de connexion des pixels, notamment à un circuit de commande (phase d'hybridation).

Un but de la présente invention est alors de proposer un procédé de fabrication de structures électroluminescentes plus simple à mettre en œuvre que les procédés connus de l'état de la technique.

Un autre but de la présente invention est également de proposer un procédé de fabrication de structures électroluminescentes qui présente un nombre d'étapes de photolithographie réduit par rapport au procédé connu de l'état de la technique.

Un autre but de la présente invention est également de proposer un procédé de fabrication de structures électroluminescentes pourvues d'une pluralité de LED dont les faces exposées sont coplanaires.

### EXPOSÉ DE L'INVENTION

Les buts de l'invention sont, au moins en partie, atteints, par un procédé de fabrication d'au moins une structure optoélectronique formée d'une pluralité de diodes électroluminescentes destinées à émettre chacune un rayonnement électromagnétique de longueur d'onde différente, le procédé comprend les étapes suivantes :
a) une étape de fourniture d'un substrat support qui comprend, sur une première face, au moins une cavité dont le fond forment, avec la première face, des marches de hauteurs respectives, dite hauteurs de marche, essentiellement égales ;
b) une étape de formation, par épitaxie, sur la première face, d'un empilement de couches qui comprend une succession d'empilements électroluminescents destinés à former chacun une diode électroluminescente, et chacun d'une épaisseur essentiellement égale à la hauteur de marche de sorte que la surface exposée dudit empilement reproduise le profil de marches, la marche la plus en retrait ainsi reproduite définissant un niveau de référence ;
c) une étape de nivellement de l'empilement de couches par rapport au niveau de référence de manière à exposer à l'environnement extérieur, et à l'aplomb de chaque marche, une section d'empilement électroluminescent différente d'une marche à l'autre, chacune des sections d'empilement électroluminescent ainsi exposée formant l'une des diodes de la pluralité de diodes électroluminescentes.

Ainsi, le procédé permet de former des diodes coplanaires, et par voie de conséquence simplifier leur procédé de formation.

Par ailleurs, la coplanarité des diodes permet également l'intégration d'au moins une structure à un autre dispositif tel qu'un dispositif de commande.

En effet, la cointégration impose généralement des étapes de collage ou d'hybridation qui se trouvent, dans le cadre de la présente invention, simplifiées du fait de la coplanarité des diodes électroluminescentes.

En outre, une seule étape de nivellement est requise pour la révélation de chacune des diodes, tandis qu'une pluralité d'étape de gravures étaient nécessaires dans les procédés connus de l'état de la technique.

La coplanarité des diodes électroluminescente facilite leur interfaçage avec un circuit de commande et/ou tout autre dispositif micro-électronique, MEMS, MOEMS.

L'interface d'une structure optoélectronique obtenue selon les termes de la présente invention peut notamment faire intervenir une ou plusieurs étapes d'assemblage, notamment des collages directs de substrats.

Selon un mode de mise en œuvre, l'étape de nivellement comprend une étape de polissage, avantageusement une étape de polissage mécano chimique.

Selon un mode de mise en œuvre, une couche de matériau diélectrique est déposée sur l'ensemble des contremarches des marches formées par le fond et la première face, la couche de matériau diélectrique étant destinée à éviter la croissance épitaxiale sur les contremarches des marches et ainsi orienter l'empilement de couches selon une direction perpendiculaire auxdites marches.

Le matériau diélectrique peut comprendre du dioxyde de silicium, ou en encore du nitrure de silicium.

Selon un mode de mise en œuvre, chaque diode électroluminescente comprend une couche de matériau semi-conducteur dopé n, dite couche inférieure sur laquelle reposent dans l'ordre une couche active, et une couche de semi-conducteur dopé p, dite couche supérieure, la couche active étant adaptée pour émettre une onde électromagnétique de longueur d'onde λ lorsqu'elle est traversée par un courant électrique, la couche active comprenant avantageusement un empilement d'une pluralité de puits quantiques.

Selon un mode de mise en œuvre, le procédé comprend également la formation de deux électrodes dites, respectivement, électrode supérieure et électrode inférieure, sur chacune des diodes, destinées à permettre le passage d'un courant électrique au travers de la couche active.

Selon un mode de mise en œuvre, pour chaque diode, l'électrode supérieure est formée sur la face exposée à l'environnement de la couche supérieure, avantageusement l'électrode supérieure est en recouvrement de l'intégralité de la face exposée à l'environnement de ladite couche supérieure.

Dès lors qu'elle recouvre la couche supérieure de la diode, l'électrode joue le rôle de réflecteur de sorte que l'extraction de lumière via la seconde face du substrat support s'en trouve améliorée.

Selon un mode de mise en œuvre, l'électrode inférieure est commune à chacune des diodes.

Selon un mode de mise en œuvre, la formation des électrodes inférieures comprend la formation de tranchées entre les diodes immédiatement adjacentes d'une même structure et ou de structures adjacentes, la formation sur les parois latérales desdites tranchées d'une couche de matériau isolant électrique et le remplissage des tranchées par un matériau métallique.

Selon un mode de mise en œuvre, pour chaque diode, à l'exception de la diode en contact direct avec le substrat support, la couche inférieure repose sur une jonction tunnel, la jonction tunnel étant formée par un empilement d'une couche de matériau semi-conducteur dopé n et d'une couche de matériau semi-conducteur dopé p, avantageusement la couche de matériau semi-conducteur dopé p étant intercalée entre la couche de matériau semi-conducteur n et la couche inférieure.

Ainsi, les contacts se font uniquement sur des couches de matériau de type n, ce qui donne de meilleurs résultats (plus faible résistance d'accès) que sur les couches de matériau de type p, surtout après une étape de gravure (étape de planarisation).

Selon un mode de mise en œuvre, chaque tranchée formée entre deux diodes adjacentes, et chacune pourvues d'une jonction tunnel, s'étend jusqu'aux jonctions tunnel desdites diodes, de sorte que le contact électrique entre l'électrode inférieure et lesdites diodes s'établisse au niveau des couches de semi-conducteur dopé n de leur jonction tunnel respective.

Selon un mode de mise en oeuvre, la cavité est formée par une succession d'étapes de gravure, avantageusement des étapes de gravure sèche, exécutées à partir de la première face.

Selon un mode de mise en oeuvre, la formation par épitaxie de l'étape b) est exécutée sur une première face faite de GaN.

Selon un mode de mise en oeuvre, le substrat support est un substrat de GaN

Selon un mode de mise en œuvre, le substrat support est un substrat de saphir sur lequel est formée une couche de GaN, la cavité étant formée dans la couche de GaN.

Selon un mode de mise en œuvre, le procédé comprend en outre une étape de transfert de l'au moins une structure optoélectronique sur un substrat d'accueil.

Selon un mode de mise en œuvre, l'étape de transfert comprend les sous-étapes suivantes :
d) l'assemblage de l'au moins une structure optoélectronique avec une face, dite face d'accueil du substrat d'accueil ;
e) le retrait du substrat support exécuté avantageusement par un chauffage laser.

Selon un mode de mise en œuvre, l'étape e) est suivie d'une étape f) de nivèlement destiné à ne conserver, parmi des reliquats d'empilements électroluminescents résultants du nivellement de l'empilement de couches exécuté à l'étape c), que les diodes électroluminescentes.

Selon un mode de mise en oeuvre, l'au moins une structure optoélectronique comprend trois diodes électroluminescentes dites, respectivement, première diode, seconde diode et troisième diode formées de trois empilements électroluminescents dits respectivement premier empilement, second empilement et troisième empilement, et formés dans cet ordre sur la première face, la première, la seconde et la troisième diodes étant chacune susceptible d'émettre un rayonnement magnétique de longueur d'onde dite, respectivement, première, seconde et troisième longueur d'onde, la première longueur d'onde étant inférieure à la seconde longueur d'onde, elle-même inférieure à la troisième longueur d'onde.

### BRÈVE DESCRIPTION DES DESSINS

D'autres caractéristiques et avantages apparaîtront dans la description qui va suivre du procédé de fabrication d'au moins une structure optoélectronique selon l'invention, donnés à titre d'exemples non limitatifs, en référence aux dessins annexés dans lesquels :
- les figures la à 1f sont des représentations schématiques d'un procédé de fabrication d'une structure optoélectronique selon un procédé, les figures la à 1f représentent le substrat support, en coupe selon un plan de coupe perpendiculaire à la première face, aux différentes étapes d'un procédé ;
- les figures 2a à 2f sont des représentations schématiques d'un procédé de fabrication d'une structure optoélectronique selon un premier mode de réalisation de la présente invention, les figures 2a à 2f représentent le substrat support, en coupe selon un plan de coupe perpendiculaire à la première face, aux différentes étapes du procédé;
- les figures 3a à 3d sont des représentations schématiques d'un procédé de formation d'une pluralité de cavités à partir de la première face d'un substrat support susceptible d'être mis en œuvre dans l'exécution du procédé de la présente invention ;
- la figure 4 est une représentation schématique d'un substrat support à l'issue de l'étape b) et pour lequel la couche de matériau diélectrique et les jonctions tunnels sont considérées ;
- les figures 5a et 5b sont des représentations schématiques des étapes du transfert de la structure optoélectronique du substrat support vers un substrat d'accueil relative à un second mode de réalisation de la présente invention.

### EXPOSÉ DÉTAILLÉ DE MODES DE RÉALISATION PARTICULIERS

La présente invention décrite de manière détaillée ci-après concerne un procédé de fabrication d'au moins une structure optoélectronique sur un substrat support.

En particulier, la présente invention concerne la fabrication d'une structure optoélectronique pourvue d'une pluralité de diodes électroluminescentes coplanaires, et formée à partir d'une succession d'empilements électroluminescents.

La présente invention met donc en œuvre une cavité, dont le fond présente un profil étagé, de sorte que la formation de la succession d'empilements électroluminescents reproduise, sur sa face exposée, le profil étagé du fond de la cavité.

L'exécution d'une étape de nivellement de la succession d' empilements électroluminescents par rapport à un niveau de référence défini par la portion de surface exposée à l'aplomb de la marche la plus profonde, permet alors de révéler un ensemble de diodes électroluminescentes coplanaires.

La description de la présente invention fait appel à des termes et expressions spécifiques qui, par souci de clarification, sont définis ci-après.

Les termes « supérieur(e) » et « inférieur(e) » sont définis en références aux figures annexées à la présente invention.

En particulier, ces termes sont définis par rapport à l'orientation du substrat support 100 lorsque ce dernier se trouve disposé horizontalement avec sa première face orientée vers le haut.

Par « dans l'ordre », on entend notamment une énumération d'éléments (par exemple des couches), notamment d'un élément le plus proche vers un élément le plus éloigné d'une référence.

La référence peut être un support comme le substrat support, et notamment sa première face.

Par « à partir de » est utilisé également pour énumérer des éléments, notamment des couches, dans l'ordre dans lequel ils apparaissent par rapport à une référence.

En particulier, une énumération de couches à partir d'une face et dans l'ordre, listera lesdites couches, de la couche la plus proche de ladite face à la couche la plus éloignée de ladite face.

Par « exposé à l'environnement » ou « exposé à l'environnement extérieur », on entend un élément sur lequel ne repose aucun autre élément, par exemple une face ou une surface libre.

Par « empilement » ou « ensemble de couche », on entend des couches reposant les unes sur les autres.

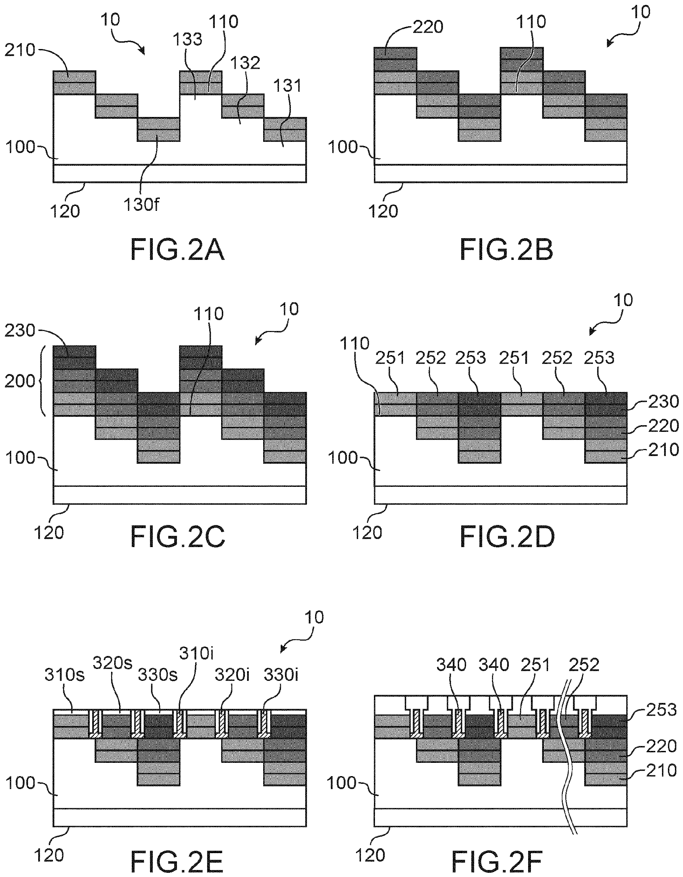

Les figures 2a à 2f sont des représentations schématiques des différentes étapes du procédé de fabrication d'une structure optoélectronique 10 formée d'une pluralité de diodes électroluminescentes destinées à émettre chacune un rayonnement électromagnétique de longueur d'onde différente selon un premier mode de réalisation de la présente invention.

En particulier, le procédé selon la présente invention comprend une étape a) de fourniture d'un substrat support 100.

Le substrat support 100 comprend notamment deux faces principales essentiellement parallèles dites, respectivement, première face 110 et seconde face 120.

La première face 110 peut être monocristalline, et en particulier comprendre un matériau semi-conducteur monocristallin.

Par exemple, le substrat support 100 peut comprendre du nitrure de gallium (GaN) massif.

De manière alternative, le substrat support 100 peut comprendre un substrat de saphir sur lequel est formée une couche monocristalline de GaN.

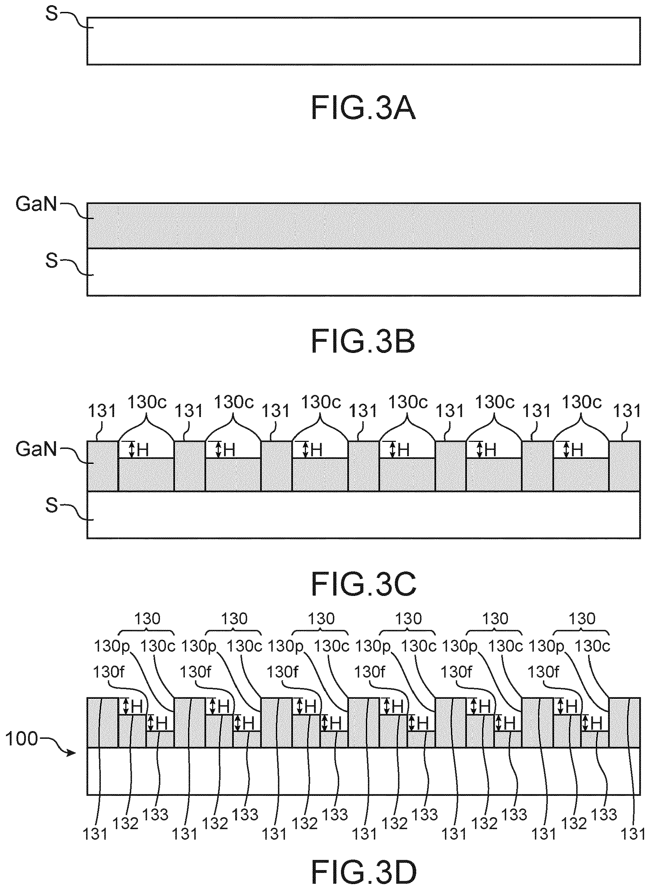

Ce substrat, tel qu'illustré aux figures 3a et 3b, peut notamment être obtenu par une croissance épitaxiale de GaN sur un substrat S.

Le substrat S peut être un substrat transparent, et à cet égard comprendre au moins un des éléments choisis parmi : saphir, carbure de silicium (SiC),spinelles (par exemple MgAl₂O₄), oxyde de zinc (ZnO).

De manière alternative, le substrat S peut être absorbant, et par exemple comprendre au moins un des éléments choisi parmi : silicium (Si), substrats composites comprenant du silicium (par exemple SOI).

Le substrat support 100 selon la présente invention comprend également une ou plusieurs cavités 130 formées à partir de sa première face 110.

Les cavités 130 peuvent être agencées de manière matricielle.

La cavité 130 comprend une paroi 130p et un fond, dit fond étagé 130f, qui forme avec la première face une pluralité de marches 131, 132, 133, chacune des marches présentant la même hauteur H, dite hauteur de marche H (figure 3d).

La cavité 130 est délimitée par un contour 130c, par exemple un contour 130c de forme rectangulaire.

La formation de la cavité 130 peut comprendre l'exécution d'une pluralité d'étapes de gravure, et notamment des gravures sèches (figures 3c à 3d).

En particulier, la formation d'une cavité 130, dont le fond étagé 130f dessine avec la première face trois marches 131, 132, 133, peut comprendre l'exécution de deux étapes de gravure dites, respectivement, première gravure et seconde gravure.

La première gravure (figure 3c) peut alors comprendre la formation d'une première sous cavité délimitée par le contour 130c et d'une profondeur correspondant à la hauteur de marche H.

La seconde gravure (figure 3d) peut comprendre la formation d'une seconde sous cavité à partir du fond de la première sous cavité et destinée à définir la marche la plus profonde du fond étagé 130f.

La seconde sous cavité est également d'une profondeur H par rapport au fond de la première sous cavité.

Le procédé selon la présente invention comprend également une étape b) de formation d'un empilement de couches 200 formées sur la première face 110 du substrat support 100.

L'empilement de couches 200 comprend notamment une succession d'empilements électroluminescents 210, 220, 230 (figures 2a à 2c).

Dans la suite de la description, le nombre d'empilements électroluminescents est limité à trois empilements électroluminescents pour des raisons de clarté, dits respectivement, à partir de la première face 110, premier empilement électroluminescent 210, deuxième empilement électroluminescent 220 et troisième empilement électroluminescent 230.

Toutefois, l'homme du métier, à la lumière de la description, est à même de généraliser les concepts présentés, et de reproduire la présente invention avec un autre nombre d'empilements électroluminescents.

Comme il apparaîtra clairement dans la suite de la description chacun de ces empilements électroluminescents est destiné à former une des diodes de la pluralité de diodes de la structure électroluminescente.

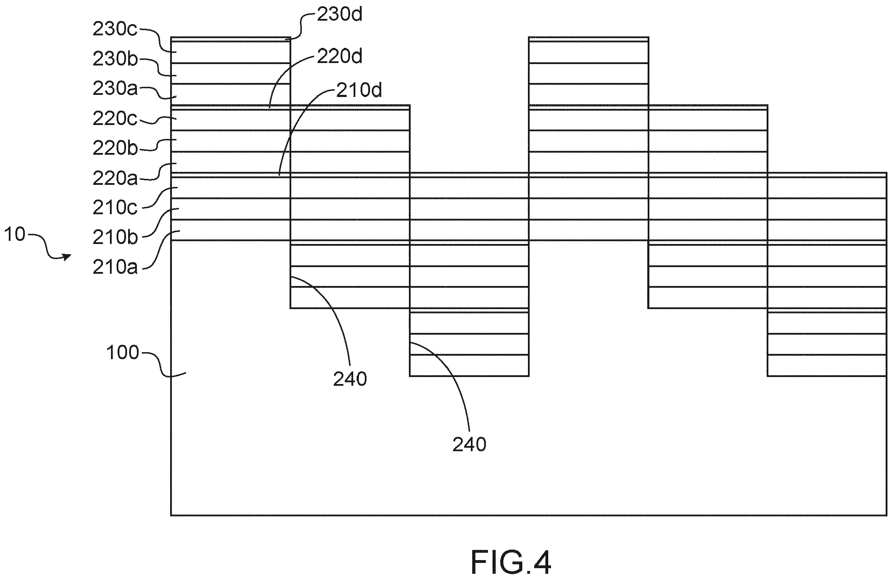

Ainsi, chacun des empilements électroluminescents peut comprendre une couche de matériau semi-conducteur dopé n 210a, 220a, 230a, dite couche inférieure 210a, 220a, 230a, sur laquelle reposent, et dans l'ordre, une couche active 210b, 220b, 230b, et une couche de semi-conducteur dopé p, dite couche supérieure 210c, 220c, 230c (figure 4).

La couche active est notamment adaptée pour émettre une onde électromagnétique de longueur d'onde λ lorsqu'elle est traversée par un courant électrique, et comprend avantageusement un empilement d'une pluralité de puits quantiques.

Ainsi, le premier empilement électroluminescent 210 comprend, dans l'ordre et à partir de la première face 110, une première couche inférieure 210a, une première couche active 210b, et une première couche supérieure 210c.

Le second empilement électroluminescent 220 comprend, dans l'ordre et à partir de la première couche supérieure 210c, une deuxième couche inférieure 220a, une deuxième couche active 220b, et une deuxième couche supérieure 220c.

Le troisième empilement électroluminescent 230 comprend, dans l'ordre et à partir de la deuxième couche supérieure 220c, une troisième couche inférieure 230a, une troisième couche active 230b, et une troisième couche supérieure 230c.

De manière particulièrement avantageuse, les empilements électroluminescents peuvent être agencés de sorte que la longueur d'onde λ susceptible d'être émise par la couche active de chaque empilement électroluminescent est supérieure à la longueur d'onde susceptible d'être émise par la couche active de l'empilement sous-jacent.

À titre d'exemple, les couches actives du premier, du second et du troisième empilement peuvent être adaptées pour émettre un rayonnement, respectivement, bleu, vert, et rouge.

La couche supérieure et la couche inférieure de chacun des empilements électroluminescents, peut comprendre du GaN dopé, respectivement, p et n.

La couche active d'un empilement électroluminescent peut comprendre un empilement de puits quantiques, par exemple un empilement de puits quantiques (Ga, In)N/(Al, Ga, In)N notamment 5 périodes de In_{0.15}Ga_{0.85}N (2nm)/ GaN (10 nm) pour l'émission d'un rayonnement bleu, ou encore 5 périodes de In_{0.40}Ga_{0.60}N (2nm)/ GaN (10 nm) pour l'émission d'un rayonnement rouge.

Les couches formant les empilements électroluminescents peuvent avantageusement être obtenues par épitaxie.

Par ailleurs, les empilements électroluminescents sont d'une épaisseur égale à la hauteur de marche H de sorte que la surface exposée de l'empilement de couches 200 reproduise le profil de marches, la marche la plus en retrait ainsi reproduite définissant un niveau de référence.

Par « marche la plus en retrait », on entend la marche la plus en retrait par rapport à la surface exposée de l'empilement de couches 200. En d'autres termes, on entend par « marche la plus en retrait », le pallier le plus profond de la cavité 130.

Il peut également être considéré dans le cadre de la présente invention de former de jonctions tunnel.

En particulier, chacun des empilements électroluminescents peut comprendre une jonction tunnel 210d, 220d, 230d (figure 4).

Notamment, la jonction tunnel 210a, 220a, 230a relative un empilement électroluminescent donné repose sur la couche supérieure dudit empilement.

Une jonction tunnel, selon la présente invention, peut comprendre un empilement formé d'une couche de matériau semi-conducteur fortement dopé p et d'une couche de matériau semi-conducteur fortement dopé n. Une telle jonction tunnel est déposée après chaque couche dopée p de chaque empilement électroluminescent.

De manière particulièrement avantageuse, l'exécution de l'étape b) peut être précédée de la formation d'une couche de matériau diélectrique 240 sur l'ensemble des contremarches des marches 131, 132, 133.

La formation de cette couche 240 peut comprendre le dépôt d'une couche de matériau diélectrique sur l'ensemble des marches et contremarches de l'au moins une cavité, suivie d'une étape de gravure du matériau diélectrique en recouvrement des marches (figure 4).

Le matériau diélectrique peut comprendre de l'oxyde de silicium ou du nitrure de silicium.

La gravure du matériau diélectrique en recouvrement des marches peut faire intervenir une gravure sèche (i.e. : par plasma), exécutée de manière anisotrope afin de graver sélectivement le matériau diélectrique en recouvrement des marches.

La couche de matériau diélectrique déposée sur l'ensemble des contremarches permet d'éviter la croissance sur lesdites contremarches, notamment d'orienter la formation par épitaxie de l'empilement de couches selon une direction perpendiculaire aux marches.

Le procédé selon la présente invention comprend également une étape c) de nivellement de l'empilement de couches par rapport au niveau de référence de manière à exposer à l'environnement extérieur, et à l'aplomb de chaque marche, une section d'empilement électroluminescent différente d'une marche à l'autre.

Chacune des sections d'empilement électroluminescent ainsi exposée forme l'une des diodes de la pluralité de diodes électroluminescentes.

En d'autres termes, la marche la plus profonde 133 conserve l'empilement de couches 200 dans son entièreté, tandis que la marche la moins profonde 131 (définie par la première face 110) ne conserve à l'issue de l'étape c) qu'un empilement électroluminescent, et en particulier le premier empilement électroluminescent formé lors de l'étape b) (figure 2d).

Ainsi, dans le cas de trois marches et de trois empilements électroluminescent, la structure optoélectronique 10 comprend à l'issue de l'étape c) :
- sur la marche la moins profonde, dite première marche 131, une première diode 251 définie par le premier empilement ;
- sur la marche intermédiaire, dite seconde marche 132, une seconde diode 252 définie par le deuxième empilement et reposant sur le premier empilement,
- sur la marche la plus profonde, dite troisième marche 133, une troisième diode 253 définie par le troisième empilement et reposant sur le premier et le deuxième empilement.

À l'issue de l'étape de nivellement, chacune des structures optoélectroniques comprend une pluralité de diodes électroluminescentes différentes exposées à l'environnement extérieur.

En particulier, lesdites diodes sont coplanaires, à l'aplomb chacune d'une marche différente, et comprennent chacune un empilement électroluminescent différent.

Notamment, chaque diode électroluminescente comprend la couche inférieure 210a, 220a, 230a, la couche active 210b, 220b, 230b, et la couche supérieure 210c, 220c, 230c de l'empilement électroluminescent à partir duquel elle est formée.

Chaque diode peut également comprendre, en recouvrement de sa couche supérieure, une jonction tunnel dès que la formation de cette dernière est considérée.

La coplanarité des diodes au sein même de la structure, ainsi que d'une structure à l'autre, permet de simplifier la formation de contacts (explicitée ci-après).

Cette coplanarité, dès lors que le substrat support est opaque aux rayonnements électromagnétiques susceptibles d'être émis par les diodes, permet de simplifier le report de la ou des structures optoélectroniques sur un autre support.

Cet aspect est également discuté dans le cadre d'un second mode de réalisation présenté dans la suite de l'énoncé.

L'étape c) de nivellement peut comprendre une étape de polissage, et notamment une étape de polissage mécanico chimique.

La mise en œuvre de l'étape de nivellement fait partie des connaissances générales de l'homme du métier, et n'est par conséquent pas décrite dans la suite de la description.

Le procédé selon la présente invention peut également comprendre, pour chacune des diodes de chacune des structures, la formation de contacts destinés à adresser de manière individuelle ou collective lesdites diodes (figure 2e).

La formation de contacts peut notamment comprendre la formation de deux électrodes dites, respectivement, électrode supérieure 310s, 320s, 330s et électrode inférieure 310i, 320i, 330i sur chacune des diodes, destinées à permettre le passage d'un courant électrique au travers de la couche active 210b, 220b, 230b.

Plus particulièrement, dès lors que la structure optoélectronique comprend trois diodes, une première électrode supérieure 310s et une première électrode inférieure 310i sont formées pour contacter la première diode 251, une seconde électrode supérieure 320s et une seconde électrode inférieure 320i sont formées pour contacter la seconde diode 252, une troisième électrode supérieure 330s et une troisième électrode inférieure 330i sont formées pour contacter la troisième diode 253.

Les électrodes supérieures 310s, 320s, 330s peuvent être formées sur la couche supérieure de chacune des diodes.

Avantageusement, l'électrode supérieure est en recouvrement de l'intégralité de la couche supérieure.

Toutefois, un contact entre l'électrode supérieure et la couche supérieure, dopée p, peut conduire à une forte résistance d'accès. Ce phénomène est par ailleurs exacerbé par l'état de surface de la couche supérieure résultant de l'étape c).

Afin de pallier ce problème, l'électrode supérieure peut, de manière alternative, être en recouvrement de la couche dopée n de la jonction tunnel, dès lors que cette dernière est considérée.

La formation des électrodes inférieures peut comprendre la formation de tranchées 340 (figure 2f) entre les diodes immédiatement adjacentes d'une même structure 10 ou de structures 10 adjacentes.

La formation des tranchées est alors suivie de la formation sur les parois latérales desdites tranchées 340 d'une couche de matériau isolant électrique et le remplissage des tranchées par un matériau métallique.

De manière avantageuse, l'électrode inférieure est commune à chacune des diodes de l'au moins une structure optoélectronique.

Les tranchées 340 formées entre diodes adjacentes peuvent s'étendre jusqu'aux jonctions tunnel desdites diodes, de sorte que le contact électrique entre l'électrode inférieure et lesdites diodes s'établisse au niveau des couches de semi-conducteur dopé n de leur jonction tunnel respective.

La formation de chacune des électrodes inférieures et des électrodes supérieures, du fait de la coplanarité des diodes, fait intervenir un nombre réduit d'étape de photolithographie par rapport au procédé décrit dans la section état de la technique.

Par conséquent, la formation des électrodes n'est plus contrainte par les requis en termes d'alignement, et permet donc d'envisager la formation de structures optoélectroniques pourvues de diodes de relativement petite taille, et notamment d'une taille de l'ordre du micromètre.

Dès lors que le substrat support 100 est transparent aux rayonnements susceptibles d'être émis par les différentes diodes, lesdits rayonnements peuvent traverser ledit support.

Les électrodes supérieures peuvent, quant à elles, jouer le rôle de réflecteurs de manière à ce que tout le rayonnement produit par les diodes soit extrait au niveau de la seconde face du substrat support 100 (figure 2f, le rayonnement émis est symbolisé par les flèches).

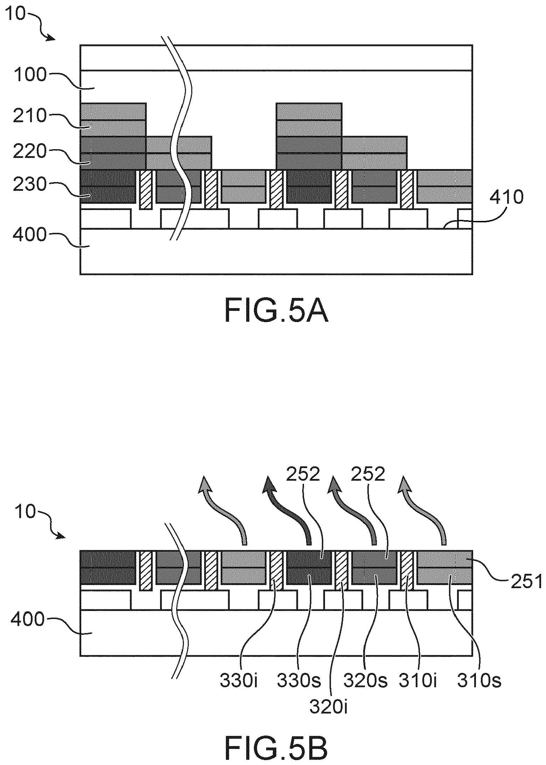

Dès lors que le substrat support 100 est opaque aux rayonnements susceptibles d'être émis par les diodes, selon un second mode de réalisation de l'invention, il peut être envisagé de reporter les structures optoélectroniques sur un substrat d'accueil 400, notamment un substrat d'accueil transparent, comme illustré sur les figures 5a et 5b.

Notamment, l'étape de transfert peut comprendre les sous-étapes suivantes :
d) l'assemblage de l'au moins une structure optoélectronique avec une face, dite face d'accueil 410 du substrat d'accueil 400 ;
e) le retrait du substrat support exécuté avantageusement par exemple avec un chauffage laser ou par abrasion mécanique, ou encore par polissage mécanico chimique.

L'étape d) d'assemblage peut, par exemple, comprendre un collage direct, ou via une couche intermédiaire telle qu'une colle.

L'étape d'assemblage peut également comprendre une hybridation avec un substrat d'accueil qui comprend un circuit de lecture sur sa face d'accueil.

Cette étape, connue de l'homme du métier, n'est pas décrite plus en détails.

Il est toutefois notable que, compte tenu de la coplanarité des diodes, l'étape d'assemblage s'en trouve simplifiée.

L'étape de retrait peut être exécutée, par exemple avec un chauffage laser, notamment par la technique dite « laser lift off » selon la terminologie Anglo-Saxonne, ou par abrasion mécanique, ou encore par polissage mécanico chimique.

L'invention ne doit toutefois pas être limitée à cette seule technique, et l'homme du métier peut envisager toute autre technique susceptible de convenir, notamment la gravure sèche ou liquide, l'abrasion.

Le transfert peut également être suivi d'une étape f) de nivellement destiné à ne conserver, parmi les reliquats d'empilements électroluminescents issus de l'étape c), que les diodes électroluminescentes.

L'étape f), à l'instar de l'étape c), peut également être exécutée par polissage, et notamment par polissage mécano chimique.

Le procédé selon la présente invention permet donc de fabriquer des structures électroluminescentes, selon un procédé simplifié par rapport aux procédés connus de l'état de la technique.

Notamment, le procédé selon la présente invention permet de limiter le nombre d'étape photolithographiques, et ouvre la voie par conséquents à l'intégration de diodes de relativement petite taille.

La coplanarité des diodes électroluminescente facilité leur interfaçage avec un circuit de commande et/ou tout autre dispositif micro-électronique, MEMS, MOEMS.

L'interface d'une structure optoélectronique obtenue selon les termes de la présente invention peut notamment faire intervenir une ou plusieurs étapes d'assemblage, notamment des collages directs de substrats.

### RÉFÉRENCES

[1] US 8,058,663 ;
[2] WO 2015/150281.

## Revendications

1. Procédé de fabrication d'au moins une structure optoélectronique (10) formée d'une pluralité de diodes électroluminescentes (251, 252, 253) destinées à émettre chacune un rayonnement électromagnétique de longueur d'onde différente, le procédé comprenant les étapes suivantes :
a) une étape de fourniture d'un substrat support (100) qui comprend, sur une première face (110), au moins une cavité (130) dont le fond (130f) forme, avec la première face (110), des marches (131, 132, 133) de hauteurs, dite hauteurs de marche, essentiellement égales ;
b) une étape de formation, par épitaxie, sur la première face (110), d'un empilement de couches (200) qui comprend une succession d'empilements électroluminescents (210, 220, 230) destinés à former chacun une diode électroluminescente, et chacun d'une épaisseur essentiellement égale à la hauteur de marche de sorte que la surface exposée dudit empilement reproduise le profil de marches, la marche la plus en retrait ainsi reproduite définissant un niveau de référence ;
c) une étape de nivellement de l'empilement de couches (200) par rapport au niveau de référence de manière à exposer, à l'environnement extérieur et à l'aplomb de chaque marche, une section d'un empilement électroluminescent différent d'une marche à l'autre, chacune des sections des empilements électroluminescents ainsi exposées formant l'une des diodes de la pluralité de diodes électroluminescentes (251, 252, 253).

2. Procédé selon la revendication 1, dans lequel l'étape de nivellement comprend une étape de polissage, avantageusement une étape de polissage mécano-chimique.

3. Procédé selon la revendication 1 ou 2, dans lequel une couche de matériau diélectrique (240) est déposée sur l'ensemble des contremarches des marches (131, 132, 133) formées par le fond (130f) et la première face (110), la couche de matériau diélectrique (240) étant destinée à éviter la croissance épitaxiale sur les contremarches des marches et ainsi à orienter la formation par épitaxie de l'empilement de couches (200) selon une direction perpendiculaire auxdites marches (131, 132, 133).

4. Procédé selon l'une des revendications 1 à 3, dans lequel chaque diode électroluminescente comprend une couche de matériau semi-conducteur dopé n, dite couche inférieure (210a, 220a, 230a) sur laquelle reposent dans l'ordre une couche active (210b, 220b, 230b), et une couche de semi-conducteur dopé p, dite couche supérieure (210a, 220c, 230c), la couche active (210b, 220b, 230b) étant adaptée pour émettre une onde électromagnétique de longueur d'onde λ lorsqu'elle est traversée par un courant électrique, la couche active (210b, 220b, 230b) comprenant avantageusement un empilement d'une pluralité de puits quantiques.

5. Procédé selon la revendication 4, dans lequel le procédé comprend également la formation de deux électrodes dites, respectivement, électrode supérieure (310s, 320s, 330s) et électrode inférieure (310i, 320i, 330i), sur chacune des diodes, destinées à permettre le passage d'un courant électrique au travers de la couche active (210b, 220b, 230b).

6. Procédé selon la revendication 5, dans lequel, pour chaque diode, l'électrode supérieure (310s, 320s, 330s) est formée sur la face exposée à l'environnement de la couche supérieure (21ca, 220c, 230c), avantageusement l'électrode supérieure (310s, 320s, 330s) est en recouvrement de l'intégralité de la face exposée à l'environnement de ladite couche supérieure (21ca, 220c, 230c).

7. Procédé selon la revendication 5 ou 6, dans lequel, l'électrode inférieure (310i, 320i, 330i) est commune à chacune des diodes des au moins une structures optoélectroniques.

8. Procédé selon l'une des revendications 5 à 7, dans lequel la formation des électrodes inférieures comprend la formation de tranchées (340) entre les diodes immédiatement adjacentes d'une même structure et ou de structures adjacentes, la formation sur les parois latérales desdites tranchées (340) d'une couche de matériau isolant électrique et le remplissage des tranchées (340) par un matériau métallique.

9. Procédé selon la revendication 8, dans lequel pour chaque diode, à l'exception de la diode en contact direct avec le substrat support, la couche inférieure (220a, 230a) repose sur une jonction tunnel, la jonction tunnel étant formée par un empilement d'une couche de matériau semi-conducteur dopé p et d'une couche de matériau semi-conducteur dopé n.

10. Procédé selon la revendication 9, dans lequel chaque tranchée formée entre deux diodes adjacentes, et chacune pourvues d'une jonction tunnel, s'étend jusqu'aux jonctions tunnel desdites diodes, de sorte que le contact électrique entre l'électrode inférieure et lesdites diodes s'établisse au niveau des couches de semi-conducteur dopé n de leur jonction tunnel respective.

11. Procédé selon l'une des revendications 1 à 10, dans lequel la cavité (130) est formée par une succession d'étapes de gravure, avantageusement des étapes de gravure sèche, exécutées à partir de la première face (110).

12. Procédé selon l'une des revendications 1 à 11, dans lequel le procédé comprend en outre une étape de transfert de l'au moins une structure optoélectronique (10) sur un substrat d'accueil (400).

13. Procédé selon la revendication 12, dans lequel l'étape de transfert comprend les sous-étapes suivantes :
d) l'assemblage de l'au moins une structure optoélectronique (10) avec une face, dite face d'accueil (410) du substrat d'accueil (400) ;
e) le retrait du substrat support exécuté avantageusement par un chauffage laser.

14. Procédé selon la revendication 12 ou 13, dans lequel l'étape e) est suivie d'une étape f) de nivellement destiné à ne conserver, parmi des reliquats d'empilements électroluminescents résultants du nivellement de l'empilement de couches exécuté à l'étape c), que les diodes électroluminescentes (251, 252, 253).

15. Procédé selon l'une des revendications 1 à 14, dans lequel l'au moins une structure optoélectronique (10) comprend trois diodes électroluminescentes (251, 252, 253) dites, respectivement, première diode (251), deuxième diode (252) et troisième diode (253) formées de trois empilements électroluminescents dits respectivement premier empilement (210), deuxième empilement (220) et troisième empilement (230), et formés dans cet ordre sur la première face (110), la première (251), la deuxième (252) et la troisième (253) diodes étant chacune susceptible d'émettre un rayonnement magnétique de longueur d'onde dite, respectivement, première, deuxième et troisième longueur d'onde, la première longueur d'onde étant inférieure à la deuxième longueur d'onde, elle-même inférieure à la troisième longueur d'onde.
